# EUROPEAN PATENT APPLICATION

(11) **EP 3 783 670 A1**
(43) Date of publication of application: **24.02.2021**
(21) Application number: 19880743.0
(22) Date of filing: 07.08.2019
(51) Int. Cl.: H01L 31/048, H02S 40/34

(54) **SHINGLED PHOTOVOLTAIC MODULE WITH DUAL POWER GENERATION UNITS**

(30) Priority: 31.10.2018 CN 201811286455
(71) Applicant: Chint Solar (Zhejiang) Co., Ltd., Hangzhou, Zhejiang 310053 (CN); Chint New Energy Development (Zhejiang) Co., Ltd., Hangzhou, Zhejiang 310053 (CN)
(72) Inventor: WANG, Gang, Hangzhou, Zhejiang 310053 (CN); LI, Junfei, Hangzhou, Zhejiang 310053 (CN); HE, Sheng, Hangzhou, Zhejiang 310053 (CN); ZHOU, Shengyong, Hangzhou, Zhejiang 310053 (CN); HUANG, Haiyan, Hangzhou, Zhejiang 310053 (CN); LU, Chuan, Hangzhou, Zhejiang 310053 (CN)
(74) Representative: Wächter, Jochen
(86) International application number: PCT/CN2019/099663
(87) International publication number: WO 2020/088027

(57) **Abstract**

The present disclosure provides a shingled photovoltaic assembly with dual power generating units comprising successively from top to bottom: an upper glass layer, an upper packaging adhesive film, a cell array layer, a lower packaging adhesive film, a back sheet and a junction box, wherein the cell array layer comprises two parallel power generating units arranged in an axisymmetric manner, wherein the power generating unit comprises a plurality of large-column cell strings in series, wherein each two large-column cell strings arranged axisymmetrically are connected in parallel to a same bypass diode, and wherein each large-column cell string includes a plurality of single-column cell strings each consisting of shingled cells in series. Since the assembly comprises two power generating units, the current flowing through each power generating unit is only half of the entire assembly, thereby effectively reducing the power loss of the assembly resulted from the hot spot effect; meanwhile, bypass diodes in the present assembly are subjected to lower voltage relative to the circuit in parallel with conventional shingled assemblies, and thus are effectively prevented from being broken down by an excessive load voltage, thus enjoying greater working stability. In addition, the dual power generating units sharing bypass diodes can significantly reduce the production cost.

## Description

### TECHNICAL FIELD

The present disclosure relates to the manufacture of photovoltaic assemblies and, in particular, to a shingled photovoltaic assembly with dual power generating units.

### BACKGROUND ART

A photovoltaic assembly is a device comprising a composite layer consisting of a glass and back sheet structure and an adhesive-packaged intermediate crystalline silicon solar cell array, which converts light energy into electricity via the photovoltaic effect. With the changes of national policies and the increase of the market competition, high conversion and high power photovoltaic assemblies are inevitably becoming the industrial trend. Shingled photovoltaic assemblies are among the preferred choices due to their higher area utilization and low resistance loss.

Compared with conventional photovoltaic assemblies, a shingled photovoltaic assembly directly bonds cells by twos in series, which avoids the use of a solder ribbon, thereby reducing the electrical and optical losses caused by the solder ribbon while increasing the utilization of the space and area; and a shingled photovoltaic assembly has higher conversion efficiency and can increase power generation by more than 7% relative to conventional photovoltaic assemblies.

An existing shingled photovoltaic assembly, taking a longitudinally arranged assembly as an example, generally only has a plurality of single-column cell strings connected in parallel between the positive and negative electrodes of the junction box; that is, the cell array layer has only one power generating unit, and there is only one bypass diode connected in parallel between the negative and positive electrodes of the assembly. Consequently, when the hot spot effect occurs in the photovoltaic assembly, not only the power loss is large, but also the bypass diode may be broken down by the excessive load voltage, thus leading to serious consequences such as burning of the assembly.

### SUMMARY OF THE DISCLOSURE

The present disclosure provides a shingled photovoltaic assembly with dual power generating units that enjoys high operational reliability and low power loss in case of a hot spot effect, the photovoltaic assembly comprising: an upper glass layer, an upper packaging adhesive film, a cell array layer, a lower packaging adhesive film and a back sheet disposed in an order from top to bottom, and a junction box disposed outside of the back sheet, wherein the cell array layer includes two power generating units connected in parallel between a positive electrode and a negative electrode of the junction box, the two power generating units axisymmetrically disposed on two sides of the centerline of the cell array layer, wherein each power generating unit includes a plurality of large-column cell strings in series, wherein every two large-column cell strings arranged axisymmetrically are connected in parallel to a same bypass diode, and wherein each large-column cell string includes a plurality of single-column cell strings each consisting of shingled cells in series.

In specific implementation, each of the large-column cell strings includes a plurality of parallel single-column cell strings.

In specific implementation, the bypass diodes each are disposed inside of an integral junction box or each of the bypass diodes is disposed in a respective sub-junction box of a split-type junction box.

In specific implementation, the plurality of said large-column cell strings in said power generating unit are arranged side by side, every two adjacent large-column cell strings having opposite polarities.

In specific implementation, said plurality of single-column cell strings within each large-column cell string are arranged side by side and have a same polarity.

In specific implementation, the cell is a one-fourth sliced cell, a one-sixth sliced cell or a one-tenth sliced cell.

In specific implementation, said power generating unit includes two said large-column cell strings, each large-column cell string comprising three single-column cell strings, each single-column cell string comprising thirty one-sixth sliced cells.

In specific implementation, said power generating unit includes four said large-column cell strings, each large-column cell string comprising three single-column cell strings, each single-column cell string comprising eighteen one-sixth sliced cells.

In specific implementation, said power generating unit includes six said large-column cell strings, each large-column cell string comprising two single-column cell strings, each single-column cell string comprising twelve one-fourth sliced cells.

In specific implementation, said power generating unit includes two said large-column cell strings, each large-column cell string comprising five single-column cell strings, each single-column cell string comprising thirty one-tenth sliced cells.

In specific implementation, the plurality of cells are connected in series and in a shingled manner via a conductive adhesive to form said single-column cell string.

In specific implementation, the plurality of large-column cell strings are connected in series via a bus bar to form said power generating unit.

In specific implementation, an insulating barrier film is further disposed between the bus bar and the cells.

The shingled photovoltaic assembly with dual power generating units provided by the present disclosure comprises an upper glass layer, an upper packaging adhesive film, a cell array layer, a lower packaging adhesive film and a back sheet disposed in an order from top to bottom, and a junction box disposed outside of the back sheet. The cell array layer includes two power generating units connected in parallel between a positive electrode and a negative electrode of the junction box, the two power generating units axisymmetrically disposed on two sides of the centerline of the cell array layer. The power generating unit includes a plurality of large-column cell strings in series, and each two large-column cell strings within the two power generating units arranged axisymmetrically are connected in parallel to a same bypass diode. Each large-column cell string includes a plurality of single-column cell strings each consisting of shingled cells in series. The assembly comprises two power generating units, and thus the current flowing through each power generating unit is only half of the entire assembly, thereby effectively reducing the power loss of the assembly resulted from the hot spot effect; meanwhile, bypass diodes in the present assembly are subjected to lower voltage relative to the circuit in parallel with conventional shingled assemblies, and thus are effectively prevented from being broken down by an excessive load voltage, thereby enjoying greater working stability. In addition, the dual power generating units sharing bypass diodes can significantly reduce the production cost.

### BRIEF DESCRIPTION OF THE DRAWINGS

In order to more clearly illustrate the specific embodiments of the present disclosure or the prior-art technical solutions, the drawings necessary for the illustrative purpose are briefly described below. It is apparent that these drawings represent only some of the specific embodiments of the present disclosure, and those skilled in the art could obtain other drawings accordingly without any inventive labor. In the drawings:
Fig. 1 is a schematic cross-sectional view showing a shingled photovoltaic assembly with dual power generating units according to an embodiment of the present disclosure;
Fig. 2 is a schematic view showing the circuit structure of a longitudinally arrayed layer of one-sixth sliced cells according to an embodiment of the present disclosure;
Fig. 3 is a schematic front view showing a longitudinally arrayed layer of one-sixth sliced cells in accordance with an embodiment of the present disclosure;
Fig. 4 is a schematic rear view showing a longitudinally aligned assembly of one-sixth sliced cells in accordance with an embodiment of the present disclosure;
Fig. 5 is a schematic view showing the circuit structure of a laterally arrayed layer of one-sixth sliced cells according to an embodiment of the present disclosure;
Fig. 6 is a schematic front view showing a laterally arrayed layer of one-sixth sliced cells in accordance with an embodiment of the present disclosure;
Fig. 7 is a schematic rear view showing a laterally aligned assembly of one-sixth sliced cells in accordance with an embodiment of the present disclosure;
Fig. 8 is a schematic view showing the circuit structure of a laterally arrayed layer of one-fourth sliced cells according to an embodiment of the present disclosure;
Fig. 9 is a schematic front view showing a laterally arrayed layer of one-fourth sliced cells in accordance with an embodiment of the present disclosure;
Fig. 10 is a schematic rear view showing a laterally aligned assembly of one-fourth sliced cells in accordance with an embodiment of the present disclosure;
Fig. 11 is a schematic view showing the circuit structure of a laterally arrayed layer of one-tenth sliced cells according to an embodiment of the present disclosure;
Fig. 12 is a schematic front view showing a laterally arrayed layer of one-tenth sliced cells in accordance with an embodiment of the present disclosure; and
Fig. 13 is a schematic rear view showing a laterally aligned assembly of one-tenth sliced cells in accordance with an embodiment of the present disclosure.

### DETAILED DESCRIPTION OF THE DISCLOSURE

To better reveal the objects, technical solutions and advantages of the present disclosure, specific embodiments of the present disclosure will be further described in detail below with reference to the accompanying drawings. These specific embodiments are intended to be illustrative of the present disclosure, but are not intended to limit the same.

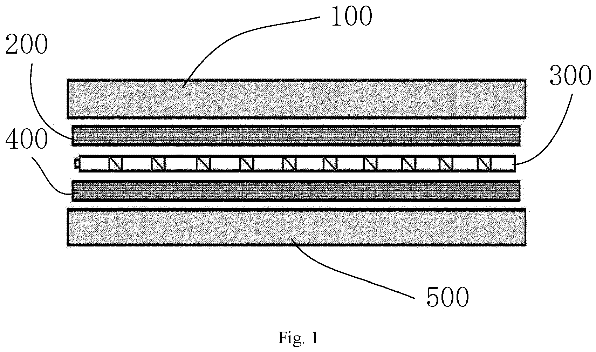

As shown in Figs. 1, 2 and 4, the present disclosure provides a shingled photovoltaic assembly with dual power generating units that enjoys high operational reliability and low power loss in case of a hot spot effect, the photovoltaic assembly comprising: an upper glass layer 100, an upper packaging adhesive film 200, a cell array layer 300, a lower packaging adhesive film 400 and a back sheet 500 disposed in an order from top to bottom, and a junction box 600 disposed outside of the back sheet 500. The cell array layer 300 includes two power generating units 301 connected in parallel between a positive electrode and a negative electrode of the junction box 600, and the two power generating units 301 axisymmetrically disposed on two sides of the centerline of the cell array layer 300. Each power generating unit 301 includes a plurality of large-column cell strings 302 in series, and each two large-column cell strings 302 arranged axisymmetrically are connected in parallel to a same bypass diode. Each large-column cell string 302 includes a plurality of single-column cell strings 303 each consisting of shingled cells 304 in series.

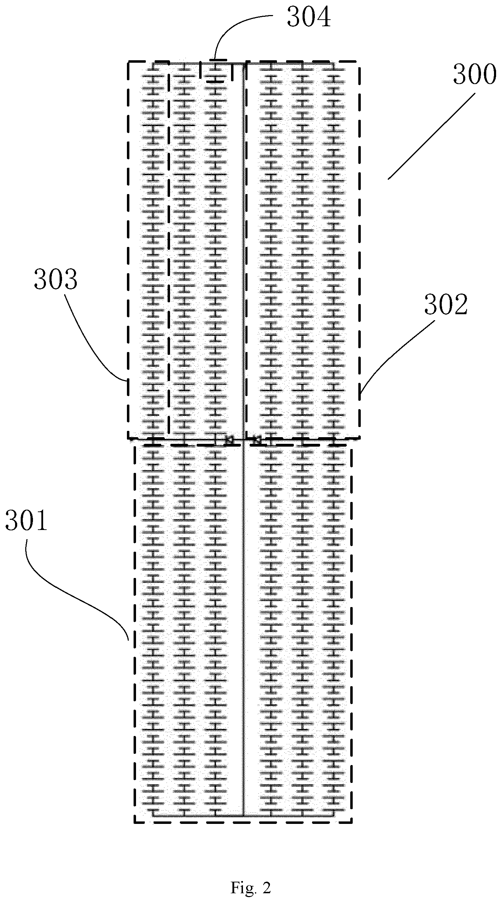

In specific implementation, the large-column cell string 302 may be in various arrangements. For example, as shown in Fig. 2, to ensure a same electrical performance as conventional assemblies, the large-column cell string 302 can include a plurality of parallel single-column cell strings 303.

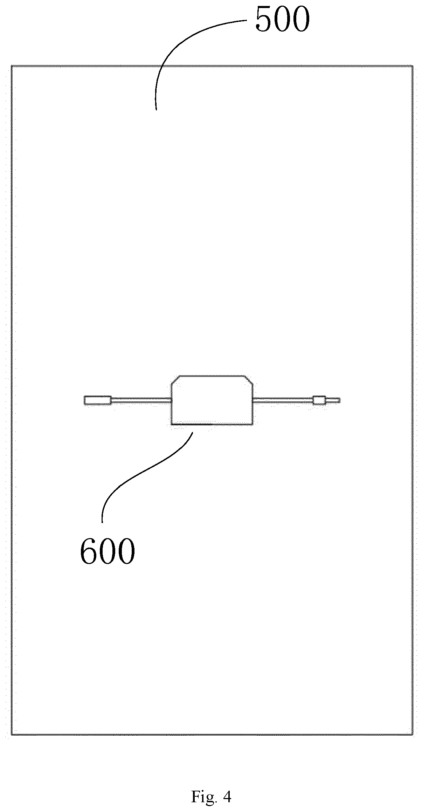

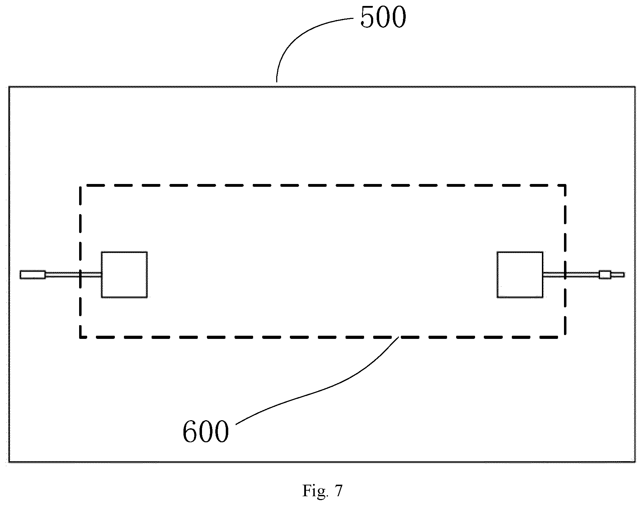

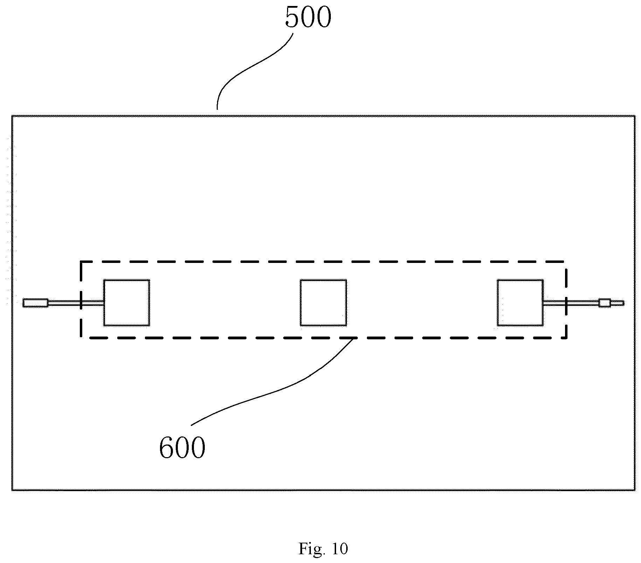

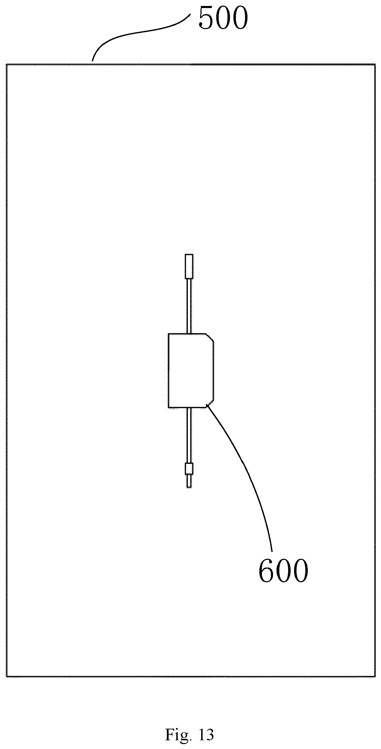

In specific implementation, the junction box 600 may take various forms. For example, as shown in Figs. 4 and 13, the junction box 600 may be an integral junction box, and each of the bypass diodes may be disposed inside of the integral junction box. Further, in order to make the connection lines between the internal bypass diodes and the large-column cell strings 302 tidy and meanwhile to take into account the connection of a plurality of bypass diodes with a plurality of large-column cell strings 302 of the two power generating units 301, the integral junction box may be disposed in the middle of the back sheet 500. For another example, as shown in Figs. 7 and 10, the junction box 600 may be a split-type junction box, with each of the bypass diodes disposed in a respective sub-junction box of the split-type junction box. Further, the number of sub-junction boxes may be matched with the number of bypass diodes, and the position of each sub-junction box may be matched with the positions of two axisymmetrically arranged large-column cell strings 302 in the two power generating units 301. Compared with the integral junction box, the position of each sub-junction box of the split-type junction box can be freely set, and thus the bypass diodes are closer to the plurality of large-column cell strings 302, such that shorter connection lines are used, thus being conducive to reducing production costs in mass production. The split-type junction box may include three sub-junction boxes provided with bypass diodes, among which one sub-junction box is located in the middle of the back sheet 500, and the other two sub-junction boxes on two sides of the back sheet 500 which are served as lead-out terminals of the positive and negative electrodes of the assembly. The split-type junction box may further include two sub-junction boxes provided with bypass diodes, the two sub-junction boxes disposed at two ends of the back sheet 500 and provided with lead-out terminals for the positive and negative electrodes of the assembly respectively.

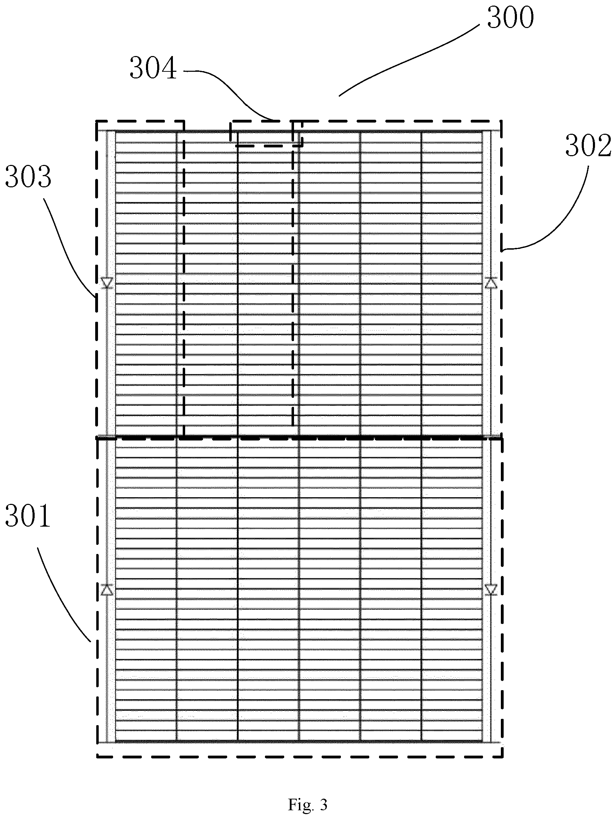

In specific implementation, the plurality of large-column cell strings 302 in the power generating units 301 may take various layouts. For example, as shown in Figs. 2 and 3, in order to make the layout of the power generating units 301 orderly and reduce the amount of a conductive medium between the plurality of large-column cell strings 302, the plurality of large-column cell strings 302 may be arranged in an "S" shape. That is, each of the large-column cell strings 302 has a polarity opposite to that of the adjacent large-column cell string 302, and the plurality of large-column cell strings 302 are connected in series, with the large-column cell strings 302 at the two ends connected to the positive and negative electrodes of the junction box 600 respectively, such that the cell array layer 300 is connected in series between the positive and negative electrodes of the junction box 600.

In specific implementation, the plurality of single-column cell strings 303 within each large-column cell string 302 may take various layouts. For example, as shown in Fig. 2, since heads and tails of the single-column cell strings 303 are connected by a conductive medium respectively, in order to make the inner layout of each large-column cell string 302 reasonable and save the conductive medium, the plurality of single-column cell strings 303 can be arranged side by side and have a same polarity. In so doing, not only the layout is neat, but also least conductive medium is used, thus reducing the cost of production.

In specific implementation, various selections may be made for the cells 304. For example, depending on the layout of the cell array layer 300, the cells 304 may be one-fourth sliced cells, one-sixth sliced cells or one-tenth sliced cells.

In specific implementation, the cells 304 within the cell array layer 300 may have various layouts. For example, as shown in Figs. 2 and 3, when one-sixth sliced cells are arranged in the longitudinal direction of the assembly, in order to ensure that the electrical performance of the assembly is the same as that of the conventional assemblies, the power generating unit 301 may include two large-column cell strings 302, each large-column cell string 302 including three single-column cell strings 303, and each single-column cell string 303 including thirty one-sixth sliced cells. In arranging the cells 304, the one-sixth sliced cells are firstly bonded by twos and connected in series to form a single-column cell string 303; for the total of twelve single-column cell strings 303, each has a same number of one-sixth sliced cells. Each three single-column cell strings 303 are connected in parallel to form a large-column cell string 302, and thus there are a total of four large-column cell strings 302. Every two large-column cell strings 302 are connected in series to form one power generating unit 301, and thus there are two power generating units 301 in total which are located in the upper and lower parts of the entire photovoltaic assembly respectively; the two power generating units 301 are connected in parallel, and bus bars for the positive and negative electrodes can be led out from the middle of the assembly. In addition, in order to ensure safety of the assembly, the four large-column cell strings 302 each are connected in parallel with bypass diodes, and the large-column cell strings 302 in the same longitudinal direction share one bypass diode, such that the entire assembly only needs two bypass diodes. In preparing one-sixth sliced cells, in order to make the assembly have a same dimension as a conventional one, the one-sixth sliced cells may have a length of 156.75 mm and a width of 26.125 mm. Since the photovoltaic assembly comprising one-sixth sliced cells of this size has a same external dimension as conventional assemblies, it can be applied with a conventional fixing frame during installation, thereby effectively relieving the adaptation problem incurred by the upgrading of assemblies while dispensing with re-design and production of a fixing frame, such that the present photovoltaic assembly can be rapidly promoted and applied.

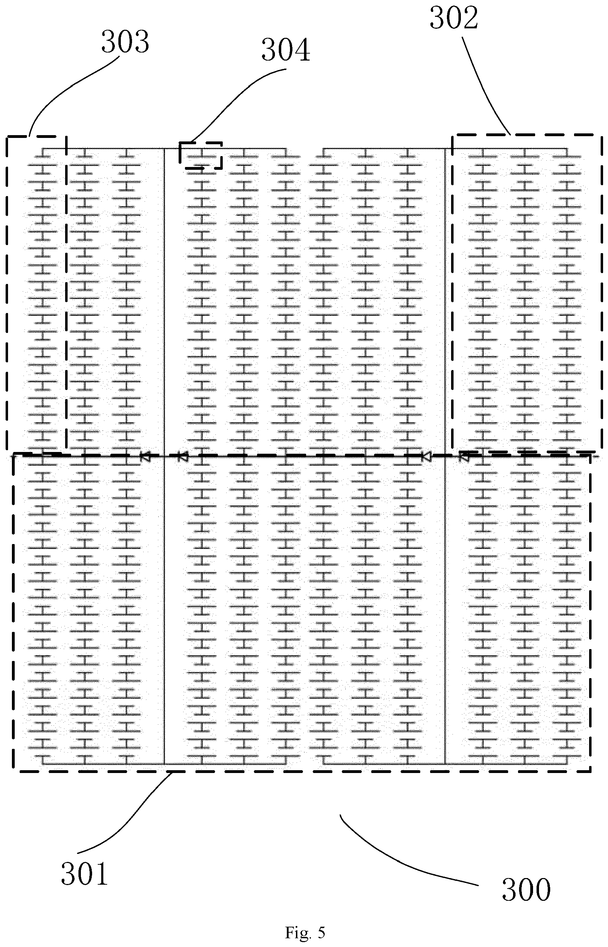

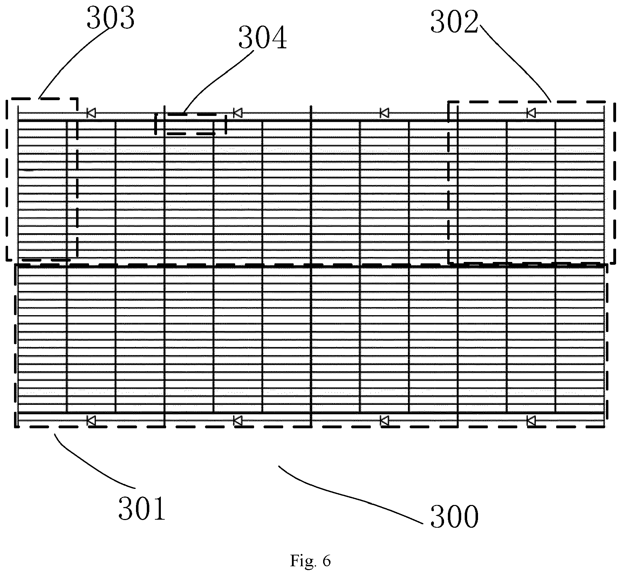

For another example, as shown in Figs. 5 and 6, when the one-sixth sliced cells are arranged in the lateral direction of the assembly, the power generating unit 301 may include four large-column cell strings 302, each large-column cell string 302 including three single-column cell strings 303 each of which includes eighteen one-sixth sliced cells. When the cell array layer 300 is arranged, on the basis of the assembly having 72 cells laterally arranged, the one-sixth sliced cells are bonded by twos and connected in series to form a single-column cell string 303; for the total of twenty-four single-column cell strings 303, each has a same number of one-sixth sliced cells. Each three single-column cell strings 303 are connected in parallel to form a large-column cell string 302, and thus there are a total of eight large-column cell strings 302. Every four large-column cell strings 302 are connected in series to form one power generating unit 301, and thus there are two power generating units 301 in total which are located in the upper and lower parts of the entire photovoltaic assembly respectively; the two power generating units 301 are connected in parallel, and bus bars for the positive and negative electrodes can be led out from the middle of the assembly. In addition, each unit in series is protected by a bypass diode in parallel. Moreover, in order to ensure safety of the assembly, the eight large-column cell strings 302 each are connected in parallel with bypass diodes, and the units in series located in the same longitudinal direction (in an axisymmetric arrangement) share one diode, such that the entire assembly needs four bypass diodes.

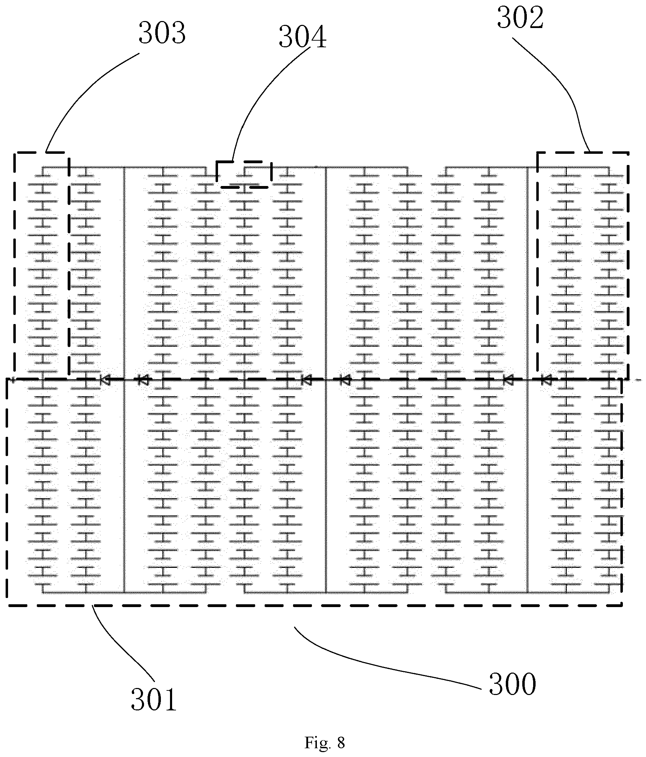

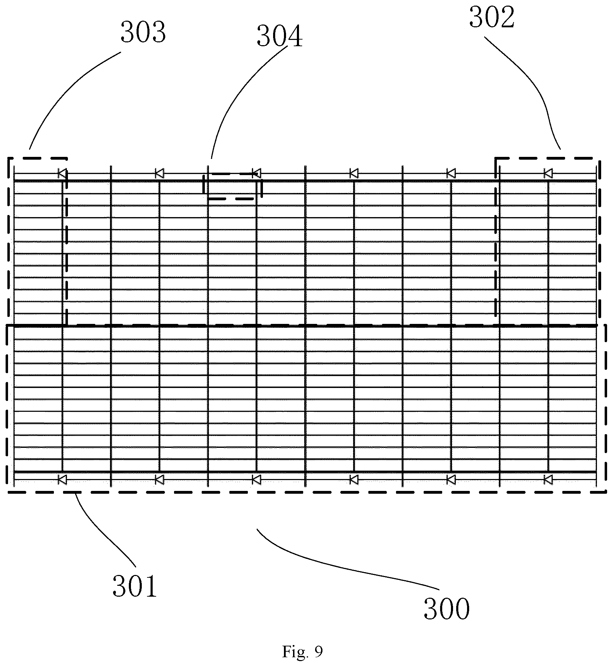

For another example, as shown in Figs. 8 and 9, when the one-fourth sliced cells are arranged in the lateral direction of the assembly, the power generating unit 301 may include six large-column cell strings 302, each large-column cell string 302 including two single-column cell strings 303 each of which includes twelve one-fourth sliced cells. When the cell array layer 300 is arranged, on the basis of the assembly having 72 cells laterally arranged, the one-fourth sliced cells are bonded by twos and connected in series to form a single-column cell string 303; for the total of twenty-four single-column cell strings 303, each has a same number of (i.e., twelve) one-fourth sliced cells. Each two single-column cell strings 303 are connected in parallel to form a large-column cell string 302, and thus there are a total of twelve large-column cell strings 302. Every six large-column cell strings 302 are connected in series to form one power generating unit 301, and thus there are two power generating units 301 in total which are located in the upper and lower parts of the entire photovoltaic assembly respectively; the two power generating units 301 are connected in parallel, and the bus bars for the positive and negative electrodes can be led out from the middle of the assembly. In addition, in order to ensure safety of the assembly, the twelve large-column cell strings 302 each are connected in parallel with the bypass diodes, and the large-column cell strings 302 in the same longitudinal direction (in an axisymmetric arrangement) share one bypass diode, such that the entire assembly needs six bypass diodes.

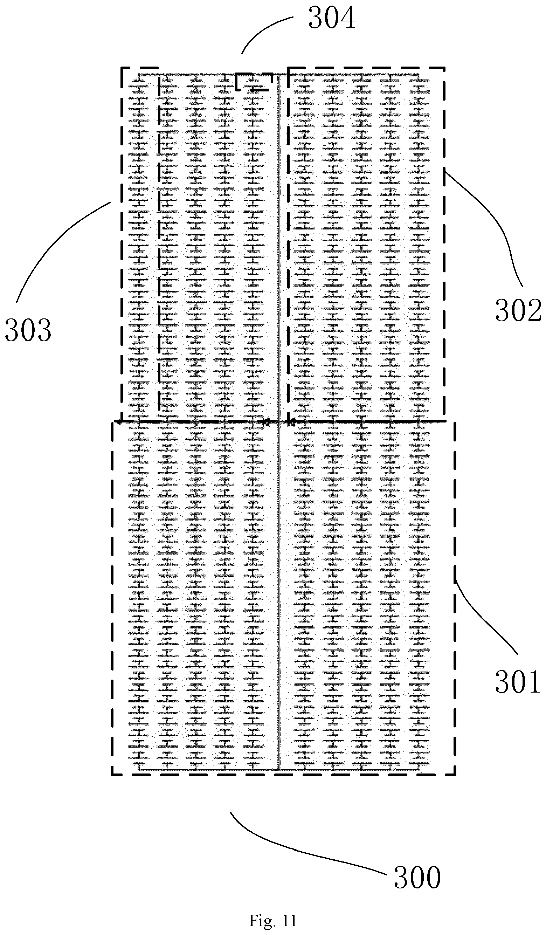

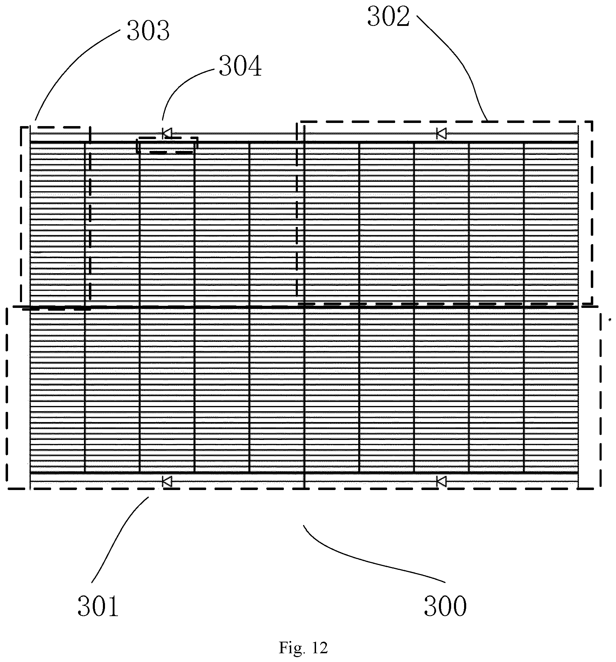

For another example, as shown in Figs. 11 and 12, when the one-tenth sliced cells are arranged in the lateral direction of the assembly, the power generating unit 301 may include two large-column cell strings 302, each large-column cell string 302 including five single-column cell strings 303 each of which includes thirty one-fourth sliced cells. When the cell array layer 300 is arranged, on the basis of the assembly having sixty cells laterally arranged, the one-tenth sliced cells are bonded by twos and connected in series to form a single-column cell string 303; for the total of twenty single-column cell strings 303, each has a same number of one-tenth sliced cells. Every five single-column cell strings 303 are connected in parallel to form a large-column cell string 302, and thus there are a total of four large-column cell strings 302. Every two large-column cell strings 302 are connected in series to form one power generating unit 301, and thus there are two power generating units 301 in total which are located in the upper and lower parts of the entire photovoltaic assembly respectively; the two power generating units 301 are connected in parallel, and bus bars for the positive and negative electrodes can be led out from the middle of the assembly. In addition, in order to ensure safety of the assembly, the units in series in the same longitudinal direction share a bypass diode, such that the entire assembly only needs two bypass diodes.

In specific implementation, the cells 304 may be bonded in series by many kinds of conductive media to form a single-column cell string 303. For example, since connecting the cells 304 via a conductive adhesive dispenses with solder ribbons and thus avoids electrical losses of the photovoltaic assembly caused thereby, the plurality of cells 304 in a single-column cell string 303 can be connected in series through a conductive adhesive in a shingled fashion.

In specific implementation, various conductive media may be selected for the parallel connection of the single-column cell strings 303 and the series connection of the plurality of large-column cell strings 302. For example, since bus bars have advantages in such aspects as inductance, anti-interference, high-frequency filtering, reliability, space, and assembling, the single-column cell strings 303 may be connected in parallel by bus bars to form a large-column cell string, and a plurality of the large-column cell strings 302 may be connected in series by the bus bars to form the cell array layer 300.

In specific implementation, since the bus bars contacting the cells 304 will generate heat during operation, which has a drainage effect on the cells 304 and thus adversely affects the power generated by the assembly, an isolating means may also be provided between the bus bars and the cells 304 so as to guarantee the operational stability of the bus bars and the cells 304. The isolating means can be implemented in a variety of ways. For example, since the insulating barrier film is inexpensive and has a strong insulating effect, it may be disposed between the bus bars and the cells 304.

In specific implementation, various selections may be made for the upper glass layer 100. For example, in order to ensure the light transmittance of the upper glass layer 100 and improve the light utilization efficiency of the photovoltaic assembly, the upper layer' s glass 100 may be a ultra-white textured tempered glass.

In specific implementation, various selections may be made for the back sheet 500. For example, the back sheet 500 may be a polymer back sheet or a glass back sheet. Further, the polymer back sheet may be a TPT back sheet, a TPE back sheet, a TPC back sheet, a KPK back sheet, a KPE back sheet, a KPF back sheet, FEVE fluorocarbon coated back sheet, a PET back sheet or a polyamide back sheet.

In specific implementation, various selections may be made for the upper packaging adhesive film 200 and the lower packaging adhesive film 400. For example, the upper packaging adhesive film 200 and the lower packaging adhesive film 400 may be EVA films due to their superiority in terms of adhesion, durability, optical characteristics, and the like.

In specific implementation, the photovoltaic assembly of the present disclosure is fabricated as follows (taking a longitudinally arranged one-sixth sliced cell array layer as an example):
Step 1: connecting the one-sixth sliced cells in series in a shingled manner to form a single-column cell string 303 through a conductive adhesive, wherein each shingled photovoltaic assembly requires a total of 360 one-sixth sliced cells, which are welded into 12 single-column cell strings 303, each single-column cell string 303 including 30 one-sixth sliced cells;
Step 2: laying the upper glass layer 100 and the upper packaging adhesive film 200;
Step 3: laying the twelve welded single-column cell strings 303 in the photovoltaic assembly; when laying, dividing them into four equal groups (four large-column cell strings 302); each large-column cell string 302 including three single-column cell strings 303 arranged in parallel, every two large-column cell strings 302 having opposite polarities constituting a power generating unit 301; and the two power generating units 301 being disposed at the upper and lower portions of the assembly respectively (axisymmetrically disposed on both sides of the centerline of the assembly);
Step 4: welding bus bars and lead-out wires for each of the laid single-column cell strings 303 to form two parallel power generating units 301; specifically, three single-column cell strings 303 of each large-column cell string 302 being firstly welded in parallel via bus bars, i.e., two bus bars being used to weld heads and tails of the three single-column cell strings 303 respectively to form a large-column cell string 302 (at the same time, a bus bar being led out from the bus bar at the head and tail of each large-column cell string respectively, where the two bus bars may be a same bus bar, i.e., a bus bar with a same potential; the bus bar being directly connected in series with a bypass diode in the junction box 600, and then the line being connected in parallel with the cell string; to protect the circuit, the bus bars led out and the cells 304 being isolated with an insulating barrier film); then the two large-column cell strings 302 being welded in series to form a power generating unit 301; lead-out wires being welded to the bus bars at the head and tail of the power generating unit 301 respectively;
Step 5: laying the lower packaging adhesive film 400 and the back sheet 500, and passing the lead-out wires through the openings of the back sheet 500;
Step 6: laminating; and
Step 7: trimming and framing the photovoltaic assembly, and mounting the junction box 600 outside of the back sheet 500.

In summary, the shingled photovoltaic assembly with dual power generating units provided by the present disclosure comprises an upper glass layer, an upper packaging adhesive film, a cell array layer, a lower packaging adhesive film and a back sheet disposed in an order from top to bottom, and a junction box disposed outside of the back sheet. The cell array layer includes two power generating units connected in parallel between a positive electrode and a negative electrode of the junction box, the two power generating units axisymmetrically disposed on two sides of the centerline of the cell array layer. Every two axisymmetrically arranged large-column cell strings within the two power generating units are connected in parallel to a same bypass diode, and each large-column cell string includes a plurality of single-column cell strings each consisting of shingled cells in series. Since the assembly comprises two power generating units, the current flowing through each power generating unit is only half of the entire assembly, thereby effectively reducing the power loss of the assembly resulted from the hot spot effect; meanwhile, bypass diodes in the present assembly are subjected to lower voltage relative to the circuit in parallel with conventional shingled assemblies, and thus are effectively prevented from being broken down by an excessive load voltage, thus enjoying greater working stability. In addition, the dual power generating units sharing bypass diodes can significantly reduce the production cost.

The objects, technical solutions and advantageous effects of the present disclosure have been described in detail through the specific embodiments as above. It is to be understood that the foregoing is only illustrative of specific preferred embodiments of the present disclosure and is not intended to limit the scope of the present disclosure. All modifications, equivalent substitutions, improvements and the like that are made within the spirit and scope of the present disclosure are intended to be included within the scope of the present disclosure as defined in the appending claims.

## Claims

1. A shingled photovoltaic assembly with dual power generating units, comprising: an upper glass layer (100), an upper packaging adhesive film (200), a cell array layer (300), a lower packaging adhesive film (400) and a back sheet (500) disposed in an order from top to bottom, and a junction box (600) disposed outside of the back sheet (500), wherein the cell array layer (300) includes two power generating units (301) connected in parallel between a positive electrode and a negative electrode of the junction box (600), the two power generating units (301) axisymmetrically disposed on two sides of the centerline of the cell array layer (300), wherein each power generating unit (301) includes a plurality of large-column cell strings (302) in series, wherein every two large-column cell strings (302) arranged axisymmetrically are connected in parallel to a same bypass diode, and wherein each large-column cell string (302) includes a plurality of single-column cell strings (303) each consisting of shingled cells (304) in series.

2. The shingled photovoltaic assembly with dual power generating units according to claim 1, wherein each of said large-column cell strings (302) comprises a plurality of parallel single-column cell strings (303).

3. The shingled photovoltaic assembly with dual power generating units according to claim 1, wherein the bypass diodes each are disposed inside of an integral junction box or each of the bypass diodes is disposed in a respective sub-junction box of a split-type junction box.

4. The shingled photovoltaic assembly with dual power generating units according to claim 1, wherein the plurality of said large-column cell strings (302) in said power generating unit (301) are arranged side by side, each two adjacent large-column cell strings (302) having opposite polarities.

5. The shingled photovoltaic assembly with dual power generating units according to claim 1, wherein said plurality of single-column cell strings (303) within each large-column cell string (302) are arranged side by side and have a same polarity.

6. The shingled photovoltaic assembly with dual power generating units according to claim 1, wherein said cell (304) is a one-fourth sliced cell, a one-sixth sliced cell or a one-tenth sliced cell.

7. The shingled photovoltaic assembly with dual power generating units according to claim 1, wherein said power generating unit (301) includes two said large-column cell strings (302), each large-column cell string (302) comprising three single-column cell strings (303), each single-column cell string (303) comprising thirty one-sixth sliced cells.

8. The shingled photovoltaic assembly with dual power generating units according to claim 1, wherein said power generating unit (301) includes four said large-column cell strings (302), each large-column cell string (302) comprising three single-column cell strings (303), each single-column cell string (303) comprising eighteen one-sixth sliced cells.

9. The shingled photovoltaic assembly with dual power generating units according to claim 1, wherein said power generating unit (301) includes six said large-column cell strings (302), each large-column cell string (302) comprising two single-column cell strings (303), each single-column cell string (303) comprising twelve one-fourth sliced cells.

10. The shingled photovoltaic assembly with dual power generating units according to claim 1, wherein said power generating unit (301) includes two said large-column cell strings (302), each large-column cell string (302) comprising five single-column cell strings (303), each single-column cell string (303) comprising thirty one-tenth sliced cells.

11. The shingled photovoltaic assembly with dual power generating units according to claim 2, wherein the plurality of cells (304) are connected in series and in a shingled manner via a conductive adhesive to form said single-column cell string (303).

12. The shingled photovoltaic assembly with dual power generating units according to claim 1, wherein the plurality of large-column cell strings (302) are connected in series via a bus bar to form said power generating unit (301).

13. The shingled photovoltaic assembly with dual power generating units according to claim 12, wherein an insulating barrier film is further disposed between the bus bar and the cells (304).
